# DEMANDE DE BREVET EUROPEEN

(11) **EP 2 741 331 A2**
(43) Date de publication de la demande: **11.06.2014**
(21) Numéro de dépôt: 13195885.2
(22) Date de dépôt: 05.12.2013
(51) Int. Cl.: H01L 27/06, B81C 1/00, H01L 27/12

(54) **Procédé de réalisation d'un composant a structure suspendue et d'un transistor co-integres sur un meme substrat**

(30) Priorité: 06.12.2012 FR 1261734
(71) Demandeur: Commissariat à l'Énergie Atomique et aux Énergies Alternatives, 75015 Paris (FR)
(72) Inventeur: OLLIER, Eric, 38100 GRENOBLE (FR); ARCAMONE, Julien, 38950 SAINT MARTIN LE VINOUX (FR); SAVOYE, Mylène, 38000 GRENOBLE (FR)
(74) Mandataire: Ilgart, Jean-Christophe

(57) **Abrégé**

L'invention concerne un procédé de réalisation d'un dispositif microélectronique comprenant, sur un même substrat, au moins un composant électro-mécanique (C) doté d'une structure suspendue et au moins un transistor (T), le procédé comprenant une étape de libération de la structure suspendue du composant électromécanique après avoir formé des niveaux métalliques d'interconnexions de composants.

## Description

### DOMAINE TECHNIQUE

La présente invention concerne le domaine des dispositifs microélectroniques dotés d'au moins un composant à structure suspendue tels que les composants NEMS (NEMS pour « Nano Electro-Mechanical Systems ») et/ou MEMS (MEMS pour « Micro Electro Mechanical Systems ») ou les capteurs, co-intégrés sur un même substrat avec au moins un composant de circuit électronique, en particulier un transistor.

Elle s'applique par exemple à la réalisation de dispositifs dotés d'un capteur inertiel (accéléromètre et/ou gyromètre), d'un capteur de masse, ou d'un dispositif RF doté de résonateurs électro-mécaniques (référence de temps, filtre, VCO,...).

### ART ANTERIEUR

Il est connu de vouloir intégrer sur un même substrat, un composant NEMS et/ou de MEMS avec un ou plusieurs transistors d'un circuit CMOS.

Une approche appelée « pre-CMOS », prévoit la réalisation d'une structure MEMS avant de réaliser les composants du circuit CMOS.

Selon une autre approche, dite « intermediate-CMOS », on interrompt les étapes de réalisation du circuit CMOS dites de « Front-End » ou celles dites de « Back-End » afin de réaliser la structure MEMS.

Une troisième approche dite « post-CMOS », prévoit de définir la structure MEMS après les composants CMOS, ce qui impose des contraintes importantes sur le choix des matériaux et des conditions du procédé utilisés afin de respecter des contraintes de budget thermique en particulier.

Un inconvénient commun à ces différentes approches est lié au nombre d'étapes de fabrication nécessaires pour réaliser le composant MEMS et le circuit CMOS.

Le document : « From VHF to UHF CMOS-MEMS monolithically integrated resonators », Teva et al., IEEE-MEMS Janvier 2008*,* présente par exemple un procédé de type « intermediate-CMOS » dans lequel la structure mécanique suspendue d'un MEMS est réalisée à partir de couches de polysilicium également utilisées pour former la grille d'un transistor MOS.

L'utilisation de cette couche en silicium polycristallin pour réaliser la structure suspendue d'un composant MEMS limite les performances mécaniques et la fiabilité du composant, ainsi que les épaisseurs de structure accessibles.

Le document« Monolithic 0.35 µm CMOS cantilever for mass sensing in the attogram range with self excitation », de J.Verd et al., transducers and eurosensors '07, ainsi que le document « monolithic integration of capacitive sensors using a double-side CMOS MEMS post process », Chih-Ming Sun et al., J. Micromech. Microeng., présentent par exemple un procédé de type « post-CMOS », dans lequel la structure suspendue de MEMS est réalisée dans une couche métallique.

Une structure suspendue de MEMS à base d'une telle couche métallique pose des problèmes d'encombrement, est dotée de performances mécaniques limitées, comporte une sensibilité à la température, et est difficile à mettre en oeuvre.

Pour limiter le nombre d'étapes du procédé de réalisation et améliorer les propriétés mécaniques du MEMS, il est connu, par exemple du document US 8 183 078 de réaliser la structure mécanique de ce dernier dans une même couche que le canal des transistors, en particulier dans une couche de silicium monocristallin.

Le document US 7 985 611 prévoit également la réalisation d'un transistor et d'une structure suspendue de MEMS dans une même couche.

Le document EP 1 695 prévoit également la réalisation d'un transistor et d'une structure suspendue de MEMS sur un même substrat.

Il se pose le problème de trouver un procédé amélioré de réalisation d'un dispositif microélectronique comportant un système électro-mécanique de type MEMS et/ou NEMS doté d'une structure suspendue, ainsi qu'un ou plusieurs transistors formés sur un même substrat.

### EXPOSÉ DE L'INVENTION

La présente invention concerne un procédé de réalisation d'un dispositif microélectronique comprenant, sur un même substrat comportant une couche semi-conductrice, au moins un composant doté d'au moins une structure suspendue et au moins un transistor, le procédé comprenant des étapes consistant à :
a) réaliser dans une première région de la couche semi-conductrice un ou plusieurs blocs sacrificiels disposés de part et d'autre ou autour d'au moins un bloc donné de ladite couche semi-conductrice destiné à former au moins une portion d'une structure suspendue dudit composant,
   - formation d'ouvertures dans ladite couche semi-conductrice puis,
   - remplissage des ouvertures par au moins un matériau diélectrique, une ou plusieurs première(s) ouverture(s) étant remplies de matériau diélectrique de manière à former lesdits blocs sacrificiels, une ou plusieurs deuxième(s) ouverture(s) étant remplies de matériau diélectrique de manière à former un ou plusieurs bloc(s) d'isolation électrique du composant,
b) former un transistor à partir d'une deuxième région de ladite couche semi-conductrice,
c) réaliser un ou plusieurs niveaux d'interconnexion dans au moins une couche isolante disposée sur ladite couche semi-conductrice,
d) former au moins une cavité dans la couche isolante de manière à dévoiler au moins partiellement ledit bloc donné destiné à former au moins une partie de structure suspendue et de manière à dévoiler au moins partiellement les blocs sacrificiels de part et d'autre de ce bloc donné semi-conducteur,
e) retirer dans ladite cavité lesdits blocs sacrificiels autour dudit bloc donné semi-conducteur, de manière à libérer ledit bloc donné formant la structure suspendue.

Le canal du transistor peut être prévu dans la couche semi-conductrice, tandis que la grille du transistor peut être réalisée à l'étape b) sur cette couche semi-conductrice.

Le bloc donné de la couche semi-conductrice peut être formé sur une couche sacrificielle que l'on retire au moins partiellement à l'étape e) lors de la libération.

Selon l'invention, à l'étape a), les deuxième(s) ouverture(s) remplies de matériau diélectrique réalisent un contour isolant fermé autour du composant électro-mécanique.

Une isolation électrique est ainsi réalisée entre le ou les composant(s) situé(s) à l'intérieur du contour et d'autres éléments situés à l'extérieur du contour fermé.

Ce contour isolant fermé autour du composant électro-mécanique est ainsi conservé à l'issue de l'étape e) de retrait des blocs sacrificiels.

Selon une première possibilité de mise en oeuvre, ce contour isolant peut être intégralement formé des blocs d'isolation.

Dans ce cas, à l'étape d) de formation de la cavité dans la couche isolante, la couche isolante est préservée au-dessus des blocs d'isolation et à l'étape e) de retrait des blocs sacrificiels, les blocs d'isolation sont entièrement conservés.

Selon une deuxième possibilité de mise en oeuvre, à l'issue de l'étape e), ce contour isolant peut être formé de portions des deuxièmes ouvertures dans lequel le matériau diélectrique de remplissage des deuxièmes ouvertures a été conservé lors de l'étape d) et de portions des deuxièmes ouvertures dans lequel le matériau diélectrique de remplissage des deuxièmes ouvertures a été retiré lors de l'étape d).

Le composant peut être un composant électro-mécanique MEMS et/ou NEMS, et selon une possibilité, être doté d'une structure suspendue mobile.

Selon une variante, la structure suspendue peut être une structure de détection, le composant étant alors par exemple un capteur.

Former la structure destinée à être suspendue avant de réaliser les transistors et les interconnexions permet de limiter les contraintes en termes de matériaux utilisés, de budget thermique, d'alignement, de choix des géométries de design, de dimensions limites des structures et de réduire les contraintes mécaniques générées dans le dispositif lors de sa fabrication. Selon l'invention, on peut réaliser le composant sans perturber les étapes de réalisation du transistor puisque celles-ci sont faites à la suite, par exemple en suivant une technologie de type CMOS.

La couche semi-conductrice peut être à base de silicium monocristallin.

On peut ainsi réaliser une structure suspendue ayant de bonnes propriétés mécaniques, en particulier en termes de fiabilité, de facteur de qualité, de module d'Young et d'élasticité.

Les niveaux d'interconnexion peuvent comprendre au moins une connexion entre le composant et le transistor.

Le bloc donné formant la structure suspendue est ancré au reste de la structure du composant par des portions qui n'ont pas été gravées lors de l'étape e).

Au cours de l'étape a), on peut former plusieurs autres blocs de matériau semi-conducteur, dont au moins un est destiné à former des moyens de commande et/ou de détection du composant, par exemple sous forme d'électrodes ou de jauges piezorésistives

Selon une possibilité de mise en oeuvre, la couche sacrificielle peut être une couche isolante d'un substrat semi-conducteur sur isolant comportant une couche de support semi-conductrice surmontée par ladite couche isolante. Le substrat peut être par exemple un substrat SOI.

Selon une possibilité de mise en oeuvre, la couche sacrificielle peut n'être présente que localement sous la couche semi-conductrice et par exemple n'être formée que dans une zone de la première région.

Selon une possibilité de mise en oeuvre, les blocs sacrificiels peuvent être à base de matériau diélectrique.

Le remplissage des première(s) ouverture(s) peut être réalisé à l'aide d'un matériau diélectrique différent du matériau diélectrique de remplissage des deuxième(s) ouverture(s).

Selon une possibilité de mise en oeuvre, les ouvertures peuvent être réalisées à travers une couche d'arrêt reposant sur la couche semi-conductrice, le procédé comprenant en outre, après remplissage des ouvertures par le matériau diélectrique, une étape de retrait de matériau diélectrique dépassant de l'embouchure des ouvertures par planarisation jusqu'à atteindre la couche d'arrêt.

Après remplissage des ouvertures, on peut effectuer une planarisation globale du substrat. La couche d'arrêt peut alors servir à marquer la fin de la planarisation.

L'étape e) peut être réalisée à l'aide d'une seule gravure ou éventuellement de plusieurs sous étapes de gravures.

Entre l'étape d) et l'étape e) on peut former une couche de protection recouvrant les flancs et le fond de la cavité, une ouverture étant ensuite pratiquée dans ladite couche de protection de manière à dévoiler ledit bloc semi-conducteur donné et lesdits blocs sacrificiels disposés de part et d'autre dudit bloc semi-conducteur donné.

La couche de protection est prévue pour protéger la ou les couches isolantes des niveaux de connexions à l'étape e) qui peut être réalisée par gravure à travers ladite ouverture.

Selon une possibilité de mise en oeuvre, l'étape e) peut être réalisée par gravure sélective du matériau de la couche sacrificielle et des blocs sacrificiels vis-à-vis du matériau semi-conducteur.

La couche de protection peut être alors à base d'un matériau résistant à ladite gravure sélective.

Selon une variante, la couche de protection peut être partiellement gravée pendant l'étape e) mais prévue suffisamment épaisse pour ne pas être totalement retirée à l'issue de la gravure à l'étape e).

Selon une possibilité de mise en oeuvre, la couche de protection peut être à base d'un matériau résistant à une gravure effectuée à l'étape e) du matériau des blocs sacrificiels et à une gravure effectuée à l'étape e) de la couche sacrificielle disposée sous ladite partie dévoilée dudit bloc donné.

Selon une possibilité de mise en oeuvre du procédé, la cavité réalisée à l'étape d) peut comporter des flancs inclinés par rapport à une normale au plan principal du substrat.

Ces flancs inclinés peuvent, suivant le type de dépôt utilisé pour la couche de protection, favoriser le recouvrement des flancs par cette couche et/ou favoriser l'étape e) de retrait.

Selon une possibilité de mise en oeuvre du procédé les deuxième(s) ouverture(s) peuvent comporter des flancs inclinés par rapport à une normale au plan principal du substrat.

Selon une possibilité de mise en oeuvre du procédé, à l'étape c) de réalisation d'un ou plusieurs niveaux de connexions électriques, on peut former une couche isolante et des contacts pour le transistor et pour le composant électromécanique dans cette couche isolante.

La formation des niveaux de connexions électriques comprend la réalisation d'une ligne conductrice de connexion entre le composant électro-mécanique et le composant électronique, cette ligne de connexion passant au-dessus d'au moins un des blocs d'isolation.

L'étape c) peut comporter en outre la formation d'au moins une autre couche isolante sur la couche isolante contenant les contacts, la ou les autres couches isolante contenant des niveaux d'interconnexions électriques reliés auxdits contacts.

Selon une possibilité de mise en oeuvre du procédé, après l'étape a) et préalablement à l'étape c), on peut former des zones dopées dans la première région de la couche semi-conductrice, le procédé comprenant en outre une étape de recuit d'activation des dopants des zones dopées de la première région et de ladite deuxième région.

Le recuit d'activation peut-être réalisée au cours de l'étape b) ou ultérieurement.

Le transistor comporte une source, un drain et une grille. La formation de zones dopées de la première région peut être réalisée après la formation de la grille du transistor et éventuellement pendant la formation de zones dopées formant la source et le drain.

Ainsi, on peut mutualiser certaines étapes de réalisation du transistor et du composant électromécanique, par exemple les étapes d'interconnexions électriques et les étapes d'activation de dopants.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- les figures 1A-1I, illustrent un exemple de procédé suivant l'invention, de réalisation d'un dispositif microélectronique doté d'au moins un composant électro-mécanique et d'au moins un composant électronique co-intégrés sur un même substrat ;
   Les figures 2A-2D illustrent certaines étapes de l'exemple de procédé de fabrication dans une région du dispositif dans laquelle la structure suspendue du composant est située ;
- la figure 3, illustre une variante de réalisation pour laquelle une cavité à flancs inclinés est formée ;
- les figures 4A-4B illustrent une variante de réalisation pour laquelle des tranchées à flancs inclinés sont réalisées ;
- la figure 5 illustre une variante de réalisation pour laquelle des trous et des tranchées sont remplis à l'aide de matériaux diélectriques différents ;
- les figures 6A-6B illustrent une variante de réalisation du procédé suivant l'invention ;
- la figure 7 illustre un dispositif dans lequel des blocs d'isolation sont formés autour de NEMS et dans des régions de séparation entre deux puces ;

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

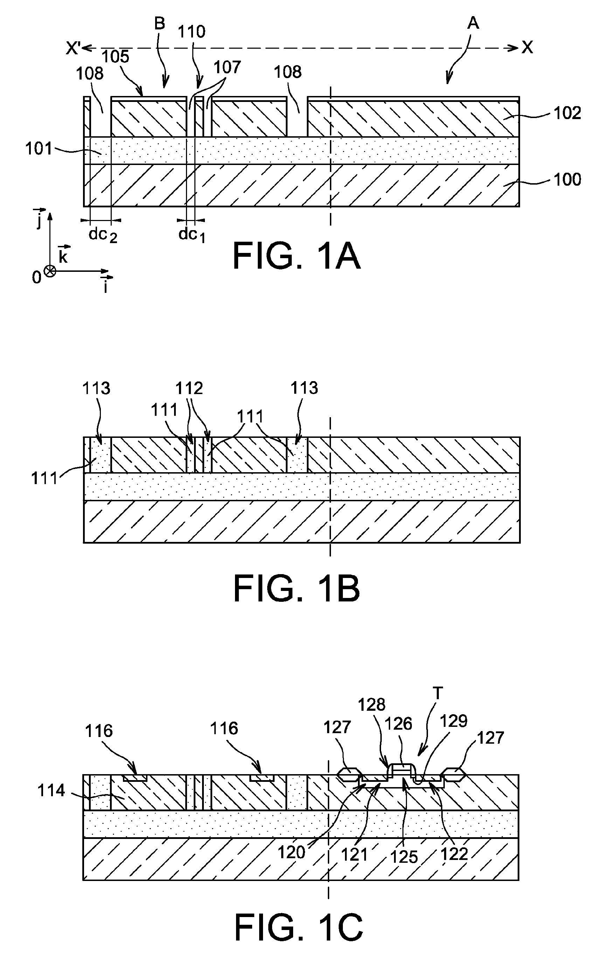

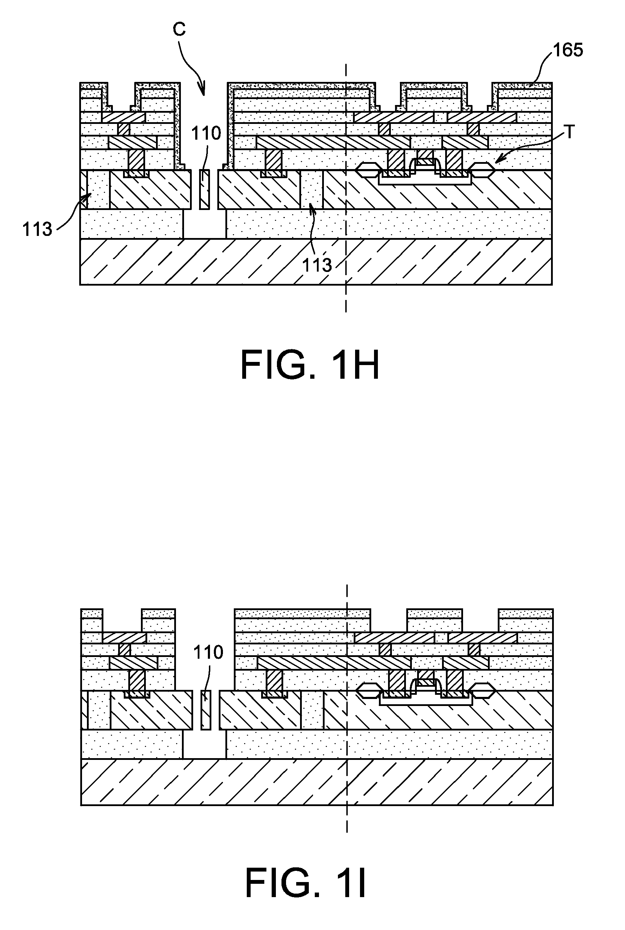

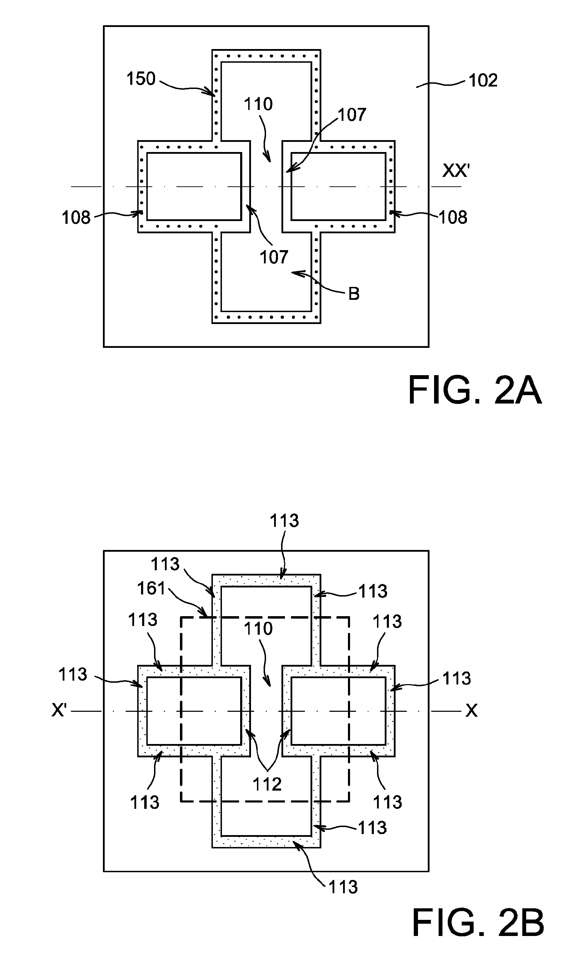

Un exemple de procédé suivant l'invention de réalisation d'un dispositif microélectronique doté d'un composant à structure semi-conductrice suspendue, tel que par exemple un composant électro-mécanique, et d'au moins un composant électronique intégrés sur un même substrat, va à présent être donné en liaison avec les figures 1A-1I (sur lesquelles le dispositif en cours de réalisation est représenté selon une vue en coupe transversale X'X) et sur les figures 2A-2D (sur lesquelles une région du dispositif dans laquelle le composant électro-mécanique est réalisé est représentée selon une vue de dessus).

Le matériau de départ de ce procédé peut être un substrat sur lequel, dans une région A, au moins un composant électronique tel qu'un transistor, par exemple en technologie CMOS, est destiné à être réalisé, tandis que dans autre région B, au moins un composant à structure suspendue, par exemple un composant électromécanique, de type résonateur MEMS ou NEMS est destiné à être formé.

Le substrat comprend au moins une couche dite « sacrificielle » surmontée d'une couche dite « technologique », de préférence semi-conductrice, dans laquelle la structure suspendue du composant électromécanique et au moins une partie d'un composant électronique, en particulier le canal du transistor, sont destinées à être formés.

La couche sacrificielle et la couche technologique sont prévues à base de matériaux différents pouvant être gravés de manière sélective l'un par rapport à l'autre.

Dans cet exemple, le substrat est de type semi-conducteur sur isolant, et comprend une couche de support 100 à base de matériau semi-conducteur, par exemple du silicium, une couche isolante 101 recouvrant la couche de support 100, et qui peut être à base de SiO₂. La couche isolante 101 peut jouer le rôle de ladite couche sacrificielle et est recouverte d'une fine couche semi-conductrice 102 pouvant quant à elle jouer le rôle de ladite couche technologique. La fine couche semi-conductrice 102 peut être formée en silicium monocristallin et a une épaisseur qui peut être comprise entre plusieurs dizaines de nanomètres et plusieurs microns ou dizaines de microns, par exemple de l'ordre de 1 µm.

Une couche 105 d'arrêt de planarisation, qui peut être à base d'un matériau diélectrique tel que par exemple du Si₃N₄, est tout d'abord formée sur la fine couche semi-conductrice 102.

Après avoir défini des motifs par photolithographie, on effectue ensuite une gravure anisotrope de cette couche 105 d'arrêt et de la fine couche semi-conductrice 102, de manière à former des trous 107 et des tranchées 108 dans la fine couche semi-conductrice 102. Par cette gravure de la fine couche semi-conductrice 102, on réalise un bloc 110 donné, destiné à former au moins une partie de structure suspendue du composant MEMS. Le bloc 110 peut être destiné par exemple à former une poutre de résonateur (figures 1A et 2A). Les tranchées 108 forment un contour isolant fermé 150 autour du composant électro-mécanique. Selon une variante (non-représentée), le contour fermé peut être également réalisé autour de circuits comportant des transistors.

Le contour isolant fermé est destiné à réaliser une isolation électrique entre le composant électro-mécanique situé à l'intérieur du contour et un ou plusieurs éléments situés à l'extérieur, dans cet exemple le transistor T.

La réalisation des trous 107 et tranchées 108, peut être simultanée ou bien par étapes successives, cette dernière approche pouvant permettre de réaliser des motifs de tranchées et de trous ayant des formes différentes.

Les largeurs des tranchées 108 et trous 107 sont prévues suffisamment importantes pour permettre d'obtenir le fonctionnement désiré de la structure électro-mécanique ainsi qu'une bonne isolation des blocs de la fine couche semi-conductrice 102 en limitant en particulier les phénomènes de couplages parasites, et suffisamment faibles pour permettre un remplissage optimal par le matériau diélectrique 111.

Les trous 107 peuvent être prévus étroits, par exemple dans le cas de la réalisation d'un NEMS à structure suspendue actionnée par commande électrostatique ou permettant de mettre en oeuvre une détection capacitive. On peut par exemple mettre en oeuvre des trous 107 de largeur dc₁ également appelée dimension critique (dimension mesurée dans une direction parallèle au plan [O ; *i̅ ; j̅*] du repère [O *; i̅ ; j̅ ; k̅*] donné sur la figure 1A) de plusieurs dizaines à plusieurs centaines de nm lorsque la couche 102 a une épaisseur comprise entre plusieurs centaines de nm à plusieurs microns ou bien encore de plusieurs microns lorsque la couche 102 a une épaisseur comprise entre plusieurs microns et plusieurs dizaines de microns.

Les tranchées 108 peuvent être prévues suffisamment larges pour permettre d'éviter des phénomènes de couplage parasite entre la structure située à l'intérieur du contour fermé 150 et le dispositif se trouvant à l'extérieur du contour.

Les tranchées 108 peuvent être prévues avec une largeur ou dimension critique dc₂ de l'ordre du micron ou plusieurs microns lorsque l'épaisseur de la couche 102 est comprise entre plusieurs centaines de nm et plusieurs dizaines de microns.

On effectue ensuite un remplissage des trous 107, et des tranchées 108 de matériau diélectrique 111, par exemple à base de SiO₂. Le matériau diélectrique 111 de remplissage des tranchées 108 et des trous 107 est de préférence prévu pour pouvoir être gravé de manière sélective vis-à-vis de celui de la fine couche semi-conductrice 102.

Le matériau diélectrique 111 de remplissage des tranchées 108 est de préférence choisi de manière à limiter les contraintes au niveau de la fine couche semi-conductrice 102. Ce matériau diélectrique 111 de remplissage peut être du type de celui, ou identique à celui de la couche isolante 101, par exemple du SiO₂.

Le remplissage des trous 107 et des tranchées 108, peut être fait de manière simultanée ou bien successive, cette dernière approche pouvant permettre de réaliser un remplissage des trous 107 avec un matériau différent de celui des tranchées 108.

On peut ensuite retirer le matériau diélectrique 111 débordant de l'embouchure des trous 107, et des tranchées 108 et se trouvant sur le masquage 105. Ce retrait peut être réalisé par polissage mécano-chimique (CMP pour « chemical-mechanical polishing » selon la terminologie anglo-saxonne) communément appelé planarisation en se servant de la couche 105 comme couche d'arrêt. On retire ensuite le masquage diélectrique 105 par gravure, par exemple à l'aide d'acide orthophosphorique H₃PO₄, sélectif vis-à-vis de la couche isolante 102 et du matériau diélectrique 111.

Des blocs à base de matériau diélectrique 111 sont ainsi réalisés au niveau de la fine couche semi-conductrice 102. Parmi ces blocs, des premiers blocs 112 formés contre et de part et d'autre du bloc 110 donné de matériau semi-conducteur, sont appelés « blocs sacrificiels » dans la mesure où ils sont destinés à être supprimés, tandis que des deuxièmes blocs 113 formés autour du bloc 110 donné et des blocs sacrificiels sont appelés « blocs d'isolation » dans la mesure où ils sont destinés à isoler électriquement le composant électromécanique du reste du dispositif, et notamment du composant électronique (figure 1B).

L'ensemble des blocs d'isolation 113 peut être agencé de manière à former un contour fermé isolant autour du composant électro-mécanique (figure 2B).

Selon une variante (non-représentée), un contour isolant peut être également formé autour de circuits comportant des transistors

Dans la région A du substrat, on forme ensuite au moins un transistor T.

La réalisation de ce transistor T peut comprendre des étapes de définition d'une zone active dans la fine couche semi-conductrice 102 délimitée par des blocs isolants 127, par exemple à l'aide d'un procédé de type LOCOS, de formation d'une région dopée 120 de caisson de type N (ou N-well selon la terminologie anglo-saxonne) ou de type P (P-well) sur laquelle sont définies une zone de source 121 et une zone de drain 122, par exemple par implantation, de formation d'une zone 125 de diélectrique de grille et d'une grille 126, de formation de zones 129 dites d'extension de type LDD et/ou PDD, et de réalisation d'espaceurs isolants 128 de part et d'autre de la grille.

Lors de la réalisation du transistor T ou après avoir réalisé le transistor T, par exemple après formation de la grille 126 et préalablement à la réalisation d'une couche diélectrique sur laquelle des niveaux d'interconnexion sont destinés à être formés, on peut effectuer dans la région B du substrat, un dopage de zones 114 de matériau semi-conducteurs de la fine couche semi-conductrice 102. Ce dopage peut être effectué simultanément à celui de certaines zones du transistor : zone de puit N, zone de puit P, extensions, dopage de la zone de source, dopage de la zone de drain.

Ce dopage est réalisé à ce stade du procédé lorsque des concentrations élevées de dopants, par exemple de l'ordre d'au moins 10¹⁹ atomes*cm⁻³ ou 10²⁰ atomes*cm⁻³ sont mises en oeuvre dans la zone B. On peut ainsi avoir aisément accès à la couche technologique 102 et éviter d'éventuels problèmes de diffusion ou relargage de dopants pendant les étapes précédentes de formation du transistor. Le dopage de la structure mécanique peut être réalisé par implantations successives avec différentes énergies d'implantation afin d'obtenir un dopage uniforme en épaisseur de la fine couche semi-conductrice 102 dans la région B. On peut en variante réaliser ce dopage au tout début du procédé lors de la formation du substrat de départ.

Certaines zones 116 situées en surface de la fine couche semi-conductrice 102, sont quant à elles dopées fortement afin d'assurer un contact électrique de qualité lors de la formation ultérieure des régions de prise de contact(s) (figure 1C).

Le ou les recuit(s) d'activation des dopants implantés dans la fine couche semi-conductrice 102 au niveau de la deuxième région B, peuvent être effectués au même moment que ceux des dopants implantés pour la formation du transistor T.

En variante, un dopage faible, par exemple inférieur à 10¹⁹ atomes*cm⁻³, de la fine couche semi-conductrice au niveau de la région B, peut être réalisé avant même la formation du bloc donné 110 par exemple par dopage intrinsèque lors de la formation de la couche 102, en particulier lorsqu'elle est partiellement réalisée par épitaxie.

Ensuite, on peut former des zones 133 d'alliage de semi-conducteur et de métal, par exemple par siliciuration.

On peut ensuite former une couche isolante 131 de type PMD (PMD pour « Pre Metal Dielectric ») par exemple à base de SiO₂ ou autres diélectriques, sur laquelle des niveaux d'interconnexion sont destinés à être réalisés.

On réalise ensuite des ouvertures dans la couche isolante 131 de type PMD dont certaines dévoilent des zones fortement dopées 116 et éventuellement les zones 133 d'alliage de semi-conducteur et de métal de la région B du substrat, d'autres ouvertures réalisées dans la région A dévoilant respectivement la région de source, la grille, et la région de drain du transistor T.

Puis, les ouvertures traversant la couche isolante 131 PMD sont remplies de matériau métallique 132, par exemple du tungstène, afin de former des contacts 134a, 135a, 136a, 134b, 135b. Le dépôt de matériau métallique peut être éventuellement précédé d'une couche barrière, par exemple à base de Ti/TiN et peut être suivi d'une étape de planarisation CMP pour retirer le matériau métallique dépassant de l'embouchure des ouvertures.

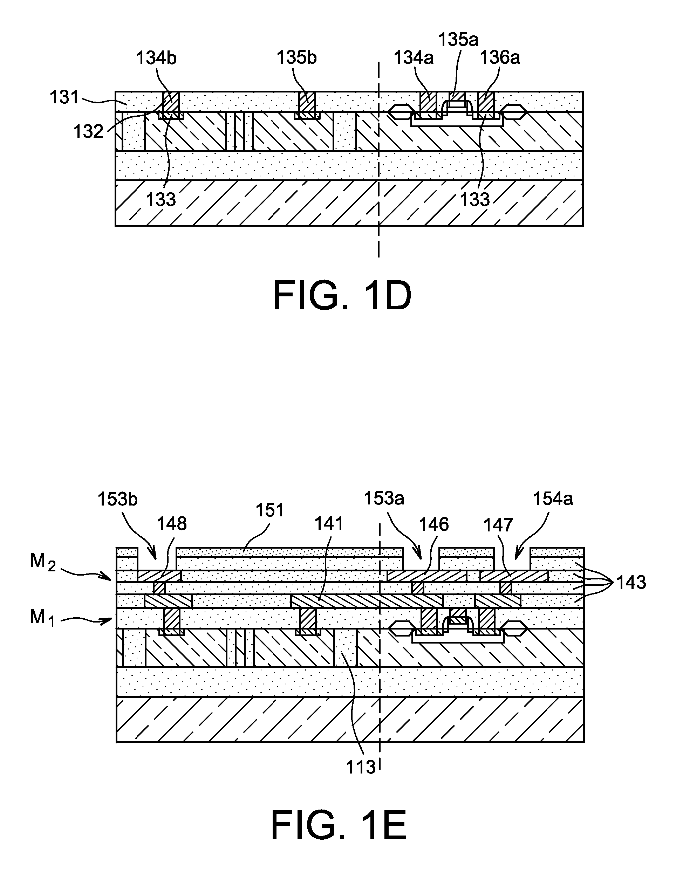

Dans la première région A du substrat 100, des contacts 134a, 135a, 136a sont ainsi formés sur la zone de source, la grille et la zone de drain du transistor T, tandis que dans la deuxième région B du substrat 100, des contacts 134b, 135b, sont réalisés pour le composant électro-mécanique (figure 1D).

Des étapes dites « de Back-end » sont ensuite réalisées, pour former un ou plusieurs niveaux métalliques d'interconnexion comportant chacun une ou plusieurs lignes conductrices horizontales, les niveaux d'interconnexion étant connectés entre eux par le biais d'interconnexions verticales communément appelés vias, l'ensemble des vias et des lignes conductrices horizontales étant réalisé dans un empilement 143 de couches isolantes.

La réalisation des niveaux métalliques d'interconnexion comporte de manière générale une succession de dépôts de matériau(x) diélectrique(s) tel(s) que de l'oxyde TeOS, du PSG et de métal tel que de l'Al, du Cu, de l'AlSi, de l'AlCu, qui sont structurés par exemple par des étapes de photolitho-gravure et de planarisation CMP. Les vias, peuvent être réalisés par exemple en tungstène.

Dans l'exemple de réalisation illustré sur la figure 1E, deux niveaux métalliques M₁, M₂, d'interconnexion sont formés sur la couche isolante 131 de type PMD. Le transistor T et le composant électromécanique sont isolés par le biais d'un bloc isolation 113 mais connectés électriquement par l'intermédiaire d'une ligne conductrice 141 qui passe au-dessus de ce bloc d'isolation 113. Cette ligne conductrice 141 peut, à titre d'exemple, appartenir au premier niveau métallique M₁ d'interconnexion.

Sur l'empilement 143 de couches isolantes, on peut former ensuite une couche 151, par exemple à base d'un matériau diélectrique tel que du Si₃N₄, dans laquelle sont pratiqués des trous en regard de lignes conductrices 146, 147, situées elles mêmes en regard de la première région A du substrat dans laquelle le transistor T est formé, et des trous en regard de lignes conductrices 148, situées elles mêmes en regard de la région B du substrat dans laquelle le composant électro-mécanique est réalisé.

On effectue alors une gravure de l'empilement à travers les trous de la couche 151, de manière à former, dans leur prolongement, des ouvertures 153a, 154a au dessus de la région A du substrat dans laquelle on réalise le transistor T, ainsi que des ouvertures 153b au niveau de la région B du substrat dans laquelle on réalise le composant électromécanique.

Les ouvertures 153a, 154a, 153b, dévoilent respectivement des zones des lignes conductrices 146, 147, 148, appartenant dans cet exemple au deuxième niveau métallique M₂ d'interconnexion (figure 1E). Ces zones dévoilées constituent des plots de contacts électriques du dispositif, permettant de relier électriquement le composant à des composants ou un dispositif extérieur(s).

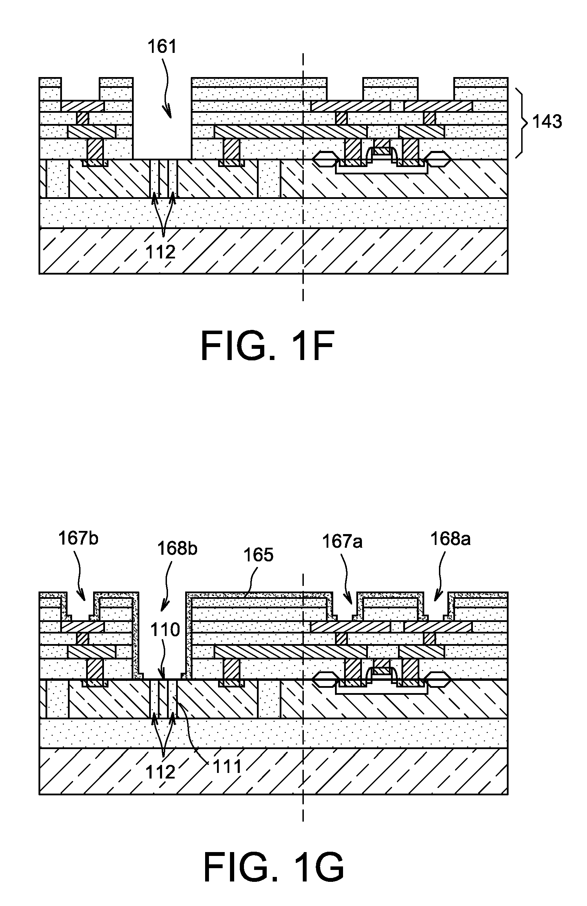

En regard de la région B du substrat, on forme ensuite par photolitho-gravure au moins une cavité 161 traversant l'empilement 143 de couches isolantes dans lequel les niveaux métalliques M₁, M₂ d'interconnexion sont réalisés (figure 1F).

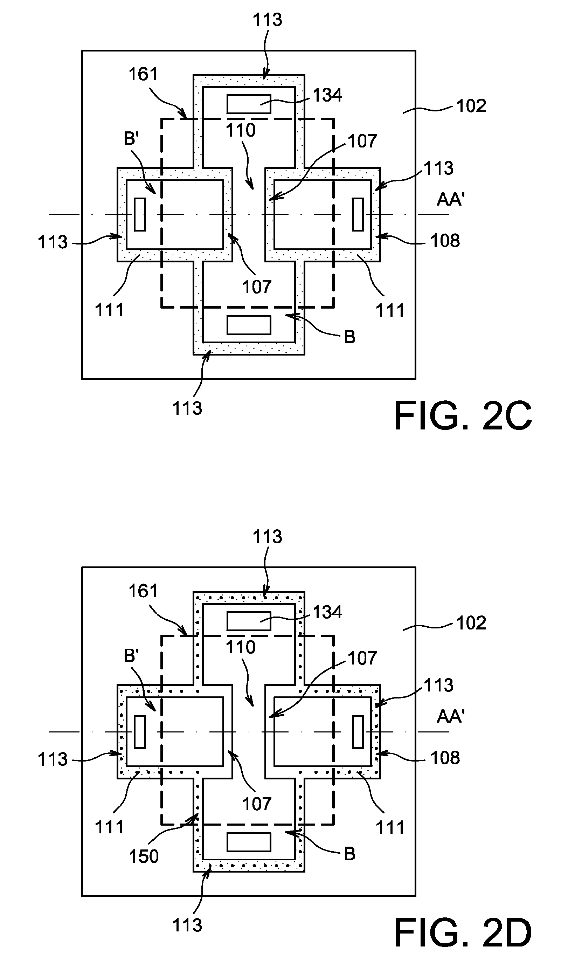

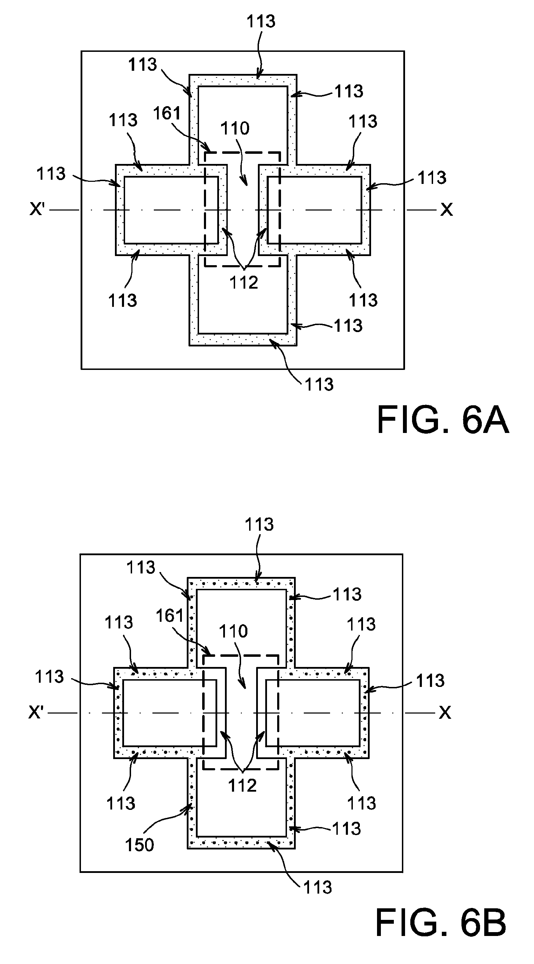

Cette cavité 161, dévoile le bloc semi-conducteur 110 de structure suspendue du composant électromécanique ainsi que les blocs sacrificiels 112 de matériau diélectrique 111 disposées de part et d'autre du bloc semi-conducteur 110. La cavité 161 peut être réalisée de sorte que les blocs 113 d'isolation sont dévoilés seulement partiellement par la cavité 161 et sont ainsi partiellement protégés par l'empilement de couches isolantes (figure 2C, sur laquelle la cavité 161 est délimitée latéralement par un contour en traits discontinus). En variante, la cavité 161 peut être réalisée de sorte que les blocs 113 d'isolation ne sont pas dévoilés par la cavité 161 et sont ainsi protégés par l'empilement de couches isolantes (figure 6A)

L'agencement des niveaux d'interconnexion M₁, M₂, de la cavité 161, et du bloc 110 est prévu de sorte que la cavité 161, ne dévoile pas de ligne métallique au-dessus du bloc 110. L'empilement 143 de couches au-dessus des blocs 110 est de préférence prévu le plus homogène possible en ce qui concerne la nature des diélectriques utilisés de façon à faciliter l'étape de gravure (figure 1F).

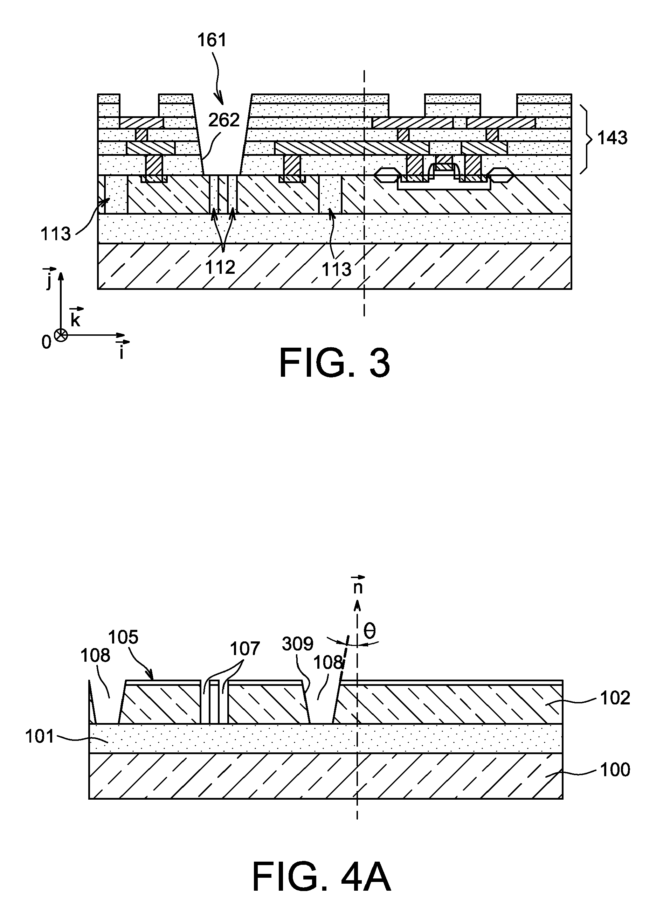

En variante (figure 3), les cavités 161, 163, peuvent être réalisées avec des parois inclinées 262 selon un angle α, par exemple de l'ordre de plusieurs degrés ou de plusieurs dizaines de degrés par rapport à une normale n au plan principal du substrat (le plan principal du substrat étant un plan passant par le substrat et parallèle au plan [O; *i̅ ; j̅*] du repère [O*; i̅ ; j̅ ; k̅*] donné sur la figure 3). Cela peut permettre de faciliter la réalisation d'une couche de protection 165 que l'on peut éventuellement former par la suite.

Une couche de protection 165 peut être prévue (figure 1G) pour protéger les matériaux de l'empilement 143 et les niveaux d'interconnexion, lors d'une étape ultérieure de libération des blocs 110.

La présence de cette couche de protection 165 permet à la fois d'empêcher un phénomène de gravure latérale de l'empilement 143 lors de la libération ultérieure des blocs 110, et de mettre en oeuvre une distance moindre entre les lignes d'interconnexions métalliques et les cavités 161.

Ainsi, les contraintes en termes de règles de dessin du dispositif sont réduites ce qui permet de mettre en oeuvre une densité d'intégration importante.

La couche de protection 165 est prévue à base d'un matériau résistant au procédé ultérieur de gravure du matériau diélectrique 111 et de la couche sacrificielle 101 qui sera réalisé pour libérer les blocs 110. Par « résistant » au procédé de gravure, on entend ici que le matériau diélectrique 111 et le matériau de la couche sacrificielle 101 pourront être gravés sans que cela entraine de gravure significative de la couche 165 et de préférence sans que cela puisse générer de résidus du matériau de la couche de protection lors de la gravure.

Le matériau de la couche de protection 165 est également choisi de manière à pouvoir être gravé de manière sélective par rapport au matériau des blocs 110.

Le matériau de la couche de protection 165 est également choisi pour pouvoir être déposé à basse température, en particulier dont la température de dépôt est d'au plus d'environ 400°C. Le matériau de la couche de protection 165 est de préférence déposé de manière conforme pour être en épaisseur suffisante sur les flancs de l'empilement 143 afin d'assurer sa fonction de protection.

La couche de protection 165 peut être par exemple une couche à base de HfO₂ permettant de protéger l'empilement 143 tandis que la libération des blocs 110 est réalisée par exemple par gravure HF isotrope.

D'autres matériaux tels que par exemple le SiC, le Si amorphe, le nitrure de silicium, l'Al₂O₃ peuvent être éventuellement utilisés pour former la couche de protection 165.

Dans cette couche de protection 165, on pratique par photolitho-gravure des ouvertures 167a, 168a, 167b, 168b, et en particulier des ouvertures 168b, au fond des cavités 161 de manière à dévoiler les blocs 110 ainsi qu'une zone autour de ces blocs 110 (figure 1H). A titre d'exemple, une couche de protection à base de HfO2 peut être gravée à l'aide d'un plasma de type BCl₃.

Au fond des cavités 161, on réalise ensuite une gravure du matériau diélectrique 111 formé autour de certaines zones de la fine couche semi-conductrice 102 ainsi qu'une gravure isotrope de la couche isolante 101 du substrat. On libère ainsi le bloc donné 110 semi-conducteur.

Cette étape de libération (figure 1E) des structures mécaniques, peut être effectuée par exemple par une gravure à l'aide de HF, en particulier lorsque le matériau diélectrique 111 et celui de la couche isolante 101 sont à base d'oxyde de silicium.

Selon une première possibilité, dans le cas où les blocs 113 d'isolation sont dévoilés seulement partiellement par la cavité 161, l'étape de libération peut conduire à un retrait partiel des portions des blocs d'isolation 113 dévoilées au fond de la cavité 161. Dans ce cas, à l'issue de cette étape de libération, le contour isolant fermé 150 entourant le composant comprend une portion des tranchées 108 remplie de matériau diélectrique 111 et une portion vide des tranchées 108 située à l'intérieur de la cavité 161 et dans laquelle le matériau diélectrique 111 a été retiré (figure 2D).

En variante, dans le cas où les blocs 113 d'isolation ne sont dévoilés pas par la cavité 161, les blocs d'isolation 113 sont entièrement conservés lors de l'étape de libération. Dans ce cas, à l'issue de la libération le contour isolant fermé 150 entourant le composant est formé des tranchées 108 entièrement remplies de matériau diélectrique 111 (figure 6B).

La couche de protection 165 peut être éventuellement ensuite retirée, par exemple à l'aide d'un plasma BCl₃ lorsqu'elle est à base de HfO₂.

Dans l'exemple de procédé qui vient d'être décrit, une zone de la couche isolante 101 disposée sous le bloc donné 110 semi-conducteur est sacrificielle dans la mesure où elle est retirée au cours du procédé. En variante, la couche sacrificielle peut être à base d'un matériau semi-conducteur différent de celui de la couche semi-conductrice 102 et susceptible d'être gravé sélectivement par rapport à celui de la couche 102, par exemple du SiGe lorsque la couche semi-conductrice 102 est à base de Si.

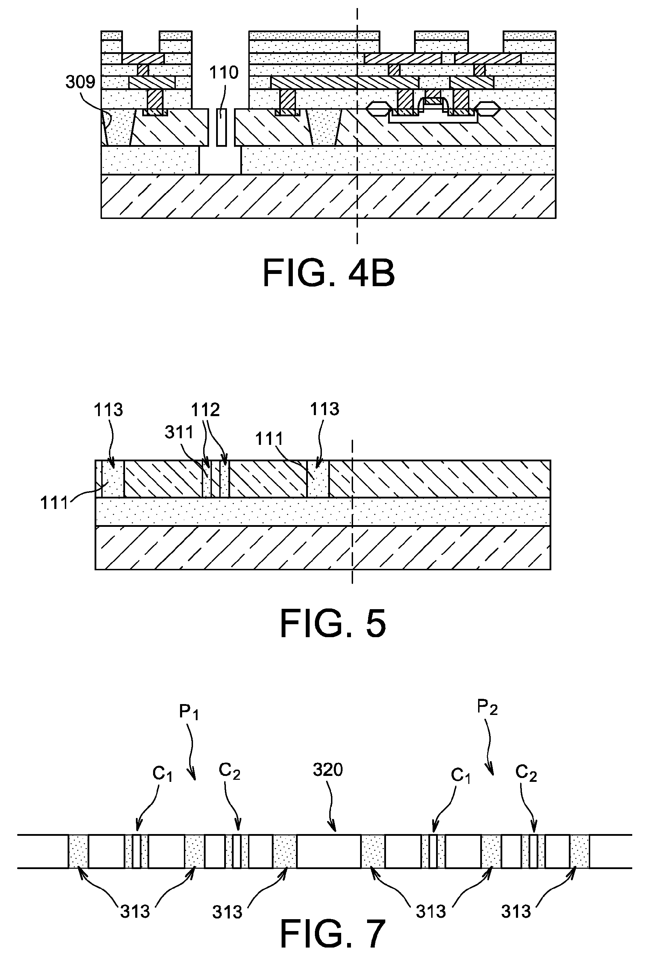

Une variante du procédé (figures 4A-4B) prévoit la mise en oeuvre de trous 107 et de tranchées 108 ayant des profils différents. On peut par exemple prévoir des trous 107 à flancs verticaux et des tranchées 108 dont les flancs présentant un angle θ non-nul avec une normale au plan principal du substrat, ce afin de faciliter le remplissage des tranchées 108.

Une autre variante du procédé (figure 5) prévoit la mise en oeuvre de blocs sacrificiels 112 et de blocs d'isolation 113 avec des matériaux diélectriques de remplissage respectifs 311 et 111 différents.

Les blocs sacrificiels 112 peuvent être à base d'un matériau diélectrique 311 présentant une bonne sélectivité de gravure par rapport au matériau de la couche 102, tandis que les blocs d'isolation 113 sont à base d'un matériau diélectrique présentant une bonne isolation électrique et apte à remplir facilement et de manière homogène des tranchées pour les parties « blocs d'isolation ».

Le matériau diélectrique 311 de remplissage des blocs sacrificiels peut être un oxyde de silicium SiO₂ ou bien un diélectrique formé par exemple à base de silane (SiH₄) ou de tetraethylorthosilicate (TEOS), un oxyde de silicium de type LTO (pour « Low Temperature Oxyde ») formé par dépôt chimique en phase vapeur basse pression ou LPCVD (pour « Low Pressure Chemical Vapor Deposition ») non dopé ou bien dopé au phosphore ou PSG (pour « phospho-Silicate-Glass ») ou encore dopé au Bore et Phosphore ou BPSG (pour « Boro-Phospho-Silicate Glass »), ou un oxyde déposé par dépôt chimique en phase vapeur assisté par plasma ou PECVD (pour « Plasma Enhanced Chemical Vapor Deposition »).

Le matériau diélectrique 111 utilisé pour remplir les blocs d'isolation 113, peut être également un oxyde de silicium, ou bien un nitrure de silicium ou encore un diélectrique de type communément appelé « low-k » ou « ultra low-k » et réalisé par voie PECVD (PECVD pour « Plasma Enhanced Chemical Vapor Deposition), comme par exemple un matériau de type SiOCH, ou un matériau de type FSG (FSG pour « Fluorosilicate Glass »), ou sous forme d'un film mince à base d'un composé de type organo-silicé synthétisé par exemple par voie sol-gel.

La figure 7 illustre un dispositif dans lequel des blocs d'isolation 313 du type de ceux décrits dans l'exemple de procédé des figures 1A-1E, sont formés autour de structures de composants NEMS C₁, C₂ et à proximité de régions 320 de frontière entre plusieurs puces P₁, P₂.

Le procédé qui vient d'être décrit s'applique à la réalisation de structures semi-conductrices suspendues par exemple d'accéléromètres, de gyromètres, de résonateurs avec des structures vibrantes en flexion ou en volume par exemple.

Le procédé qui vient d'être décrit s'applique également à la réalisation d'autres composants à structures semi-conductrices suspendues, par exemple à des capteurs chimiques ou biologiques.

## Revendications

1. Procédé de réalisation d'un dispositif microélectronique comprenant, sur un même substrat comportant une couche semi-conductrice (102), au moins un composant (C) doté d'au moins une structure suspendue et au moins un transistor (T), le procédé comprenant des étapes consistant à :
a) réaliser dans une première région de la couche semi-conductrice un ou plusieurs blocs sacrificiels disposés de part et d'autre ou autour d'au moins un bloc donné de ladite couche semi-conductrice destiné à former au moins une portion d'une structure suspendue dudit composant et un ou plusieurs bloc(s) d'isolation électrique du composant, les blocs sacrificiels et les blocs isolants étant réalisés par :
- formation d'ouvertures dans ladite couche semi-conductrice puis,
- remplissage des ouvertures par au moins un matériau diélectrique, une ou plusieurs première(s) ouverture(s) étant remplies de matériau diélectrique de manière à former lesdits blocs sacrificiels, une ou plusieurs deuxième(s) ouverture(s) étant remplies de matériau diélectrique de manière à former un ou plusieurs bloc(s) d'isolation électrique du composant, les deuxième(s) ouverture(s) remplies de matériau diélectrique réalisant un contour isolant fermé autour dudit composant (C),
b) former un transistor à partir d'une deuxième région de ladite couche semi-conductrice,
c) réaliser un ou plusieurs niveaux d'interconnexion dans au moins une couche isolante disposée sur ladite couche semi-conductrice,
d) former au moins une cavité dans la couche isolante de manière à dévoiler au moins partiellement ledit bloc donné destiné à former au moins une partie de structure suspendue et de manière à dévoiler au moins partiellement les blocs sacrificiels de part et d'autre de ce bloc donné semi-conducteur,
e) retirer dans ladite cavité lesdits blocs sacrificiels et une couche sacrificielle autour dudit bloc donné semi-conducteur (110), de manière à libérer ledit bloc donné (110) formant la structure suspendue.

2. Procédé selon la revendication 1, dans lequel l'étape e) de retrait est réalisée par gravure et dans lequel, entre l'étape d) et l'étape e) on forme une couche de protection (165) recouvrant les flancs et le fond de la cavité, une ouverture (168b) étant ensuite pratiquée dans ladite couche de protection (165) de manière à dévoiler ledit bloc semi-conducteur donné et lesdits blocs sacrificiels (112) disposés de part et d'autre dudit bloc semi-conducteur (110), la couche de protection (165) protégeant la ou les couches isolantes des niveaux de connexions à l'étape e).

3. Procédé selon la revendication 2, dans lequel les blocs sacrificiels sont à base d'un matériau diélectrique (111), la couche de protection (165) étant à base d'un matériau résistant à ladite gravure dudit matériau diélectrique (111) et à une gravure de la couche sacrificielle (101) disposée sous ladite partie dévoilée dudit bloc donné (110) effectuée à l'étape e).

4. Procédé selon l'une des revendications 1 à 3, dans lequel la cavité (161) réalisée à l'étape d) comporte des flancs inclinés par rapport à une normale au plan principal du substrat.

5. Procédé selon la revendication 4, dans lequel les ouvertures (107, 108) sont réalisées à travers une couche d'arrêt (105) reposant sur la couche semi-conductrice (102), le procédé comprenant en outre, après remplissage des ouvertures (107, 108) par le matériau diélectrique (111), une étape de retrait de matériau diélectrique dépassant de l'embouchure des ouvertures (107, 108) par planarisation jusqu'à atteindre la couche d'arrêt (105).

6. Procédé selon l'une des revendications 1 à 5, dans lequel la formation des niveaux de connexions électriques (134, M₁, M₂) comprend la formation d'une ligne conductrice de connexion (141) électrique entre le composant électro-mécanique et le composant électronique passant au-dessus d'un des blocs d'isolation (113) séparant et isolant le composant électro-mécanique et le composant électronique.

7. Procédé selon l'une des revendications 1 à 6, dans lequel après l'étape a) et préalablement à l'étape c), on forme des zones dopées dans la première région (B) et la deuxième région de la couche semi-conductrice (102), le procédé comprenant en outre une étape de recuit d'activation des dopants dites zones dopées de la première région et de ladite deuxième région.

8. Procédé selon l'une des revendications 1 à 7, dans lequel la couche semi-conductrice (102) est à base de silicium monocristallin.

9. Procédé selon l'une des revendications 1 à 8, dans lequel la couche sacrificielle (101) est une couche isolante d'un substrat semi-conducteur sur isolant, cette couche isolante étant intercalée entre une couche de support semi-conductrice (100) et la couche semi-conductrice (102).

10. Procédé selon l'une des revendications 1 à 9, dans lequel le remplissage des première(s) ouverture(s) (107) est réalisé à l'aide d'un matériau diélectrique (311) différent du matériau diélectrique (111) de remplissage des deuxième(s) ouverture(s) (108).

11. Procédé selon l'une des revendications 1 à 10, dans lequel les première(s) ouverture(s) (107) ont un profil différent de celui des deuxième(s) ouverture(s) (108), les deuxième(s) ouverture(s) comportant des flancs inclinés par rapport à une normal au plan principal du substrat.

12. Procédé selon l'une des revendications 1 à 11, dans lequel à l'étape d) de formation de la cavité, les blocs d'isolation sont entièrement recouverts par la couche isolante, les blocs d'isolation étant entièrement conservés à l'étape e) de retrait des blocs sacrificiels dans ladite cavité.

13. Procédé selon l'une des revendications 1 à 11, dans lequel à l'étape d) de formation de la cavité les blocs d'isolation sont partiellement dévoilés par la cavité isolante, les blocs d'isolation étant partiellement conservés à l'étape e) de retrait des blocs sacrificiels dans ladite cavité, une portion du contour isolant fermé autour dudit composant étant à l'issue de l'étape e) formé d'une portion des deuxièmes ouvertures dans lequel le matériau diélectrique de remplissage des deuxièmes ouvertures a été conservé lors de l'étape d) et d'une portion des deuxièmes ouvertures dans lequel le matériau diélectrique de remplissage des deuxièmes ouvertures a été retiré lors de l'étape d).
